(19) Europäisches Patentamt
European Patent Office
Office européen des brevets

(11) **EP 3 022 593 B1**

(12) **FASCICULE DE BREVET EUROPEEN**

(45) Date de publication et mention de la délivrance du brevet:
**07.10.2020 Bulletin 2020/41**

(21) Numéro de dépôt: **14739415.9**

(22) Date de dépôt: **11.07.2014**

(51) Int Cl.:
***G02B 6/12*** *(2006.01)*

(86) Numéro de dépôt international:
**PCT/EP2014/064992**

(87) Numéro de publication internationale:
**WO 2015/007663 (22.01.2015 Gazette 2015/03)**

(54) **COUPLEUR OPTIQUE MUNI D'UN GUIDE D'ONDES INTERMÉDIAIRE**

OPTISCHER KOPPLER MIT EINEM ZWISCHENSCHICHT-WELLENLEITER

OPTICAL COUPLER PROVIDED WITH AN INTERMEDIATE WAVEGUIDE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **15.07.2013 FR 1356952**

(43) Date de publication de la demande:
**25.05.2016 Bulletin 2016/21**

(73) Titulaires:
• **Commissariat à l'Energie Atomique et aux Energies Alternatives**
**75015 Paris (FR)**
• **Alcatel Lucent**
**91620 Nozay (FR)**

(72) Inventeurs:
• **LABEYE, Pierre**
**F-38000 Grenoble (FR)**
• **BOUTAMI, Salim**
**F-38100 Grenoble (FR)**
• **BRUN, Mickaël**
**F-38320 Eybens (FR)**
• **NICOLETTI, Sergio**
**F-38650 Sinard (FR)**

(74) Mandataire: **Lavoix**
**2, place d'Estienne d'Orves**
**75441 Paris Cedex 09 (FR)**

(56) Documents cités:
WO-A1-02/44780          US-A1- 2002 154 848
US-A1- 2006 182 402    US-B1- 6 411 765

**Description**

La présente invention concerne un coupleur optique, un composant comprenant un tel coupleur optique, un procédé de détermination et un procédé de fabrication d'un tel coupleur optique.

L'invention se situe dans le domaine de l'intégration hétérogène de sources lasers sur une structure optique intégrée. De telles intégrations trouvent des applications dans différents domaines utilisant les composants de la photonique intégrée. Parmi les applications, il existe les télécommunications optiques, les capteurs optiques ou la biophotonique. Pour ces différentes applications, il existe un besoin pour des structures permettant de guider efficacement la lumière.

La photonique intégrée s'est développée sur des substrats comme le verre, le silicium ou les matériaux III-V. On rappelle qu'un semi-conducteur de type « III - V » est un semi-conducteur composite fabriqué à partir d'un ou plusieurs éléments de la colonne III du tableau périodique des éléments (bore, aluminium, gallium, indium, ...) et d'un ou plusieurs éléments de la colonne V ou pnictogènes (azote, phosphore, arsenic, antimoine ...). Il est souhaitable d'utiliser plutôt des substrats en silicium puisque les substrats en silicium permettent d'intégrer à la fois des composants optiques et des composants électroniques.

Toutefois, il n'existe pas encore de source laser monolithique efficace sur silicium. Pour pallier ce problème, ce sont des intégrations hétérogènes de source laser utilisant des matériaux III-V sur un substrat silicium qui sont généralement utilisées.

Pour obtenir un couplage efficace de la lumière laser créée par la source laser dans le matériau III-V avec la structure guidante en silicium, il a été proposé de coupler, par des ondes évanescentes, un guide d'ondes passif de la structure guidante en silicium avec la source laser. Le couplage est lié au rapport entre l'amplitude du champ électrique de l'onde circulant dans le guide d'ondes passif et l'amplitude du champ électrique de l'onde émis par la source laser. Plus précisément, le couplage est défini par la formule $C = I2/(I1+I2)$, où C est le couplage, I1 est l'intensité du champ électrique dans le laser et I2 l'intensité du champ électrique dans le guide d'onde passif. Par ailleurs, on rappelle qu'un guide d'ondes passif est un guide d'ondes dépourvu d'élément actif.

L'obtention du couplage entre la source laser et le guide d'ondes passif impose que la source laser soit très proche du guide d'ondes passif. Le couplage dépend en effet fortement de l'espacement entre la source laser et le guide d'ondes passif. Cette proximité est souvent difficile à obtenir en pratique puisqu'il convient de protéger le guide d'ondes passif par le dépôt d'une couche isolante dégradant la source laser, notamment à cause de la température à laquelle est réalisé le dépôt.

Pour contourner ce problème, il est proposé dans le document WO-A-03/054 596 de réaliser un guide d'ondes passif comportant un relief optique à efficacité graduelle. US 6,411,765 B1 divulgue les caractéristiques de la préambule de la revendication 1.

Toutefois, ce type de structure est difficile à réaliser dans une technologie impliquant du silicium.

De plus, généralement, le guide d'ondes passif comporte un cœur et une gaine comme la source laser. Lorsque l'indice optique du cœur de la source laser est inférieur à l'indice optique de la gaine du guide d'ondes passif, des fuites des mode(s) guidé(s) dans le cœur de la source laser ont lieu vers la gaine du guide d'ondes passif.

Il existe donc un besoin pour un coupleur optique limitant les fuites des modes guidés dans la source laser vers le substrat.

A cet effet, l'invention a pour objet un coupleur optique selon la revendication 1.

Un tel coupleur limite les fuites des modes guidés dans la source laser vers le substrat.

Un tel coupleur optique permet d'obtenir un meilleur couplage. Le coupleur optique est aisé à fabriquer puisque seules des techniques issues de la microélectronique sont employées.

Suivant des modes de réalisation particuliers, le coupleur optique comprend une ou plusieurs des caractéristiques suivantes, prise(s) isolément ou suivant toutes les combinaisons techniquement possibles :

- lesdits paramètres du troisième guide d'ondes influant sur le couplage par ondes évanescentes entre le premier guide d'ondes et le deuxième guide d'ondes sont choisis de sorte que le couplage soit supérieur à 30%, de préférence supérieur à 50%.
- le troisième guide d'ondes comporte une troisième gaine et un troisième cœur, chaque gaine d'un guide d'ondes présentant un indice optique inférieur à l'indice optique du cœur de chaque guide d'ondes adjacent au guide d'ondes de la gaine considérée.
- le premier guide d'ondes est un guide d'ondes actif et les deuxième et troisième guides d'ondes sont des guides d'ondes passif.
- le premier cœur est réalisé dans un matériau appartenant à la colonne III du tableau périodique composé avec un matériau selon la colonne V du tableau périodique et deux couches inférieure et supérieure entourant le cœur.
- le troisième guide d'ondes comporte une couche supérieure, une couche inférieure et un troisième cœur, le troisième cœur du troisième guide d'ondes ayant une dimension variable le long de la direction transversale.
- le coupleur optique comporte un substrat, formé dans un premier matériau de préférence du silicium, dans lequel le deuxième guide d'ondes et le troisième guide d'ondes sont enfouis, le premier guide d'ondes étant agencé en contact avec le substrat et formé dans un matériau différent du premier matériau.
- le deuxième guide d'ondes est à une distance d'au moins 5 millimètres du premier guide d'ondes dans la direction transversale.
- le coupleur optique comprend, en outre, un quatrième guide d'ondes distincts des premier, deuxième et troisième guides d'ondes et s'étendant parallèlement aux premier, deuxième et troisième guide d'ondes, le quatrième guide d'ondes étant agencé entre le troisième guide d'ondes et le deuxième guide d'ondes et présentant des paramètres influant sur le couplage par ondes évanescentes entre le premier guide d'ondes et le deuxième guide d'ondes, l'ensemble des paramètres du troisième guide d'ondes et du quatrième guide d'ondes étant choisis de sorte que le couplage soit supérieur à 15%.
- les paramètres du troisième guide d'ondes et du quatrième guide d'ondes influant sur le couplage par ondes évanescentes entre le premier guide d'ondes et le deuxième guide d'ondes sont choisis de sorte que le couplage soit supérieur à 30%, de préférence supérieur à 50%.

L'invention concerne aussi un composant optique comportant un coupleur optique tel que précédemment décrit.

En outre, la présente invention a également pour objet un procédé de détermination de paramètres d'un coupleur optique selon la revendication 11.

En outre, l'invention se rapporte aussi à un procédé de fabrication d'un coupleur optique tel que précédemment décrit, comprenant des étapes de fabrication des différents guides d'ondes impliquant des techniques de dépôt, d'épitaxie, de polissage et d'enlèvement de matière par gravure.

Le procédé de fabrication permet d'obtenir le coupleur optique précédemment décrit avec uniquement des techniques issues de la microélectronique. De telles techniques sont de mise en œuvre particulièrement aisée.

D'autres caractéristiques et avantages de l'invention apparaîtront à la lecture de la description qui suit de modes de réalisation de l'invention, donnés à titre d'exemple uniquement et en référence aux dessins qui sont :

- figure 1, une vue schématique en coupe d'un coupleur optique selon un premier mode de réalisation de l'invention,
- figure 2, une cartographie du champ électrique dans le coupleur optique selon la figure 1 en fonctionnement,
- figure 3, un graphique présentant l'évolution spatiale de la répartition du couplage dans les différents guides d'ondes pour le coupleur optique selon la figure 1,
- figure 4, une cartographie du champ électrique dans un coupleur optique selon l'état de la technique,
- figure 5, un graphique présentant l'évolution spatiale de la répartition du couplage dans les différents guides d'ondes pour le coupleur optique selon l'état de la technique considéré à la figure 4,
- figures 6 à 13, des représentations schématiques en coupe de l'élément obtenu à différents stades de la mise en œuvre du procédé de fabrication du coupleur optique selon le premier mode de réalisation illustrée par la figure 1,
- figure 14, une vue schématique en coupe d'un coupleur optique selon un deuxième mode de réalisation de l'invention,
- figure 15, une cartographie du champ électrique dans le coupleur optique selon la figure 14 en fonctionnement, et
- figure 16, un graphique présentant l'évolution spatiale de la répartition du couplage dans les différents guides d'ondes pour le coupleur optique selon la figure 14.

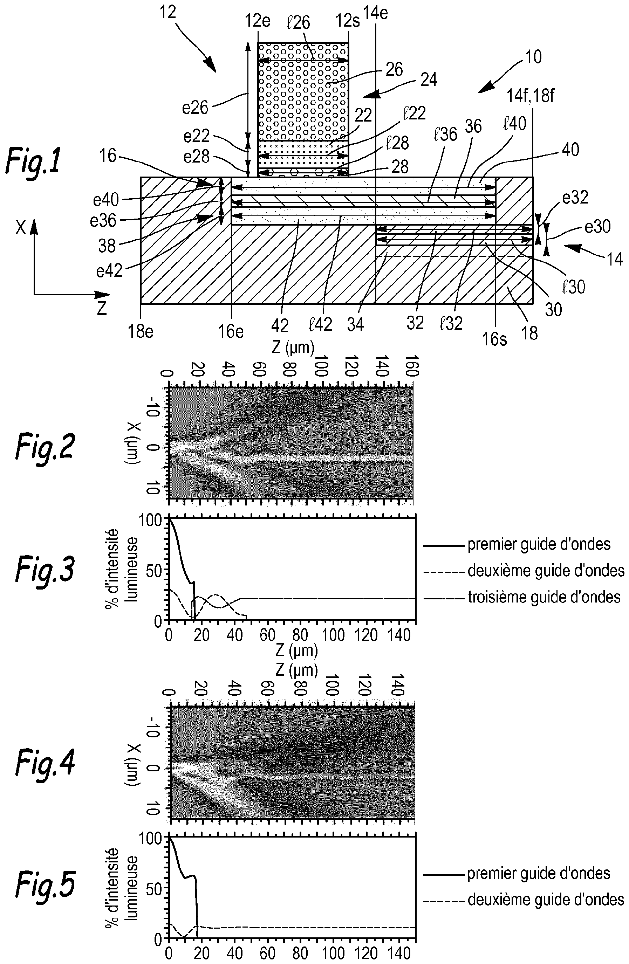

Dans le cadre de l'invention, il est proposé un coupleur 10 optique tel que représenté sur la figure 1.

Ce coupleur 10 est dans une configuration verticale, c'est-à-dire une configuration dans laquelle ce coupleur optique 10 est propre à coupler de la lumière entre deux guides décalés dans une direction transversale perpendiculaire à une direction générale de la propagation de la lumière.

Le coupleur optique 10 comprend un premier guide d'ondes 12 s'étendant selon une direction longitudinale Z, et un deuxième guide d'ondes 14 distinct du premier guide d'ondes 12 et s'étendant parallèlement au premier guide d'ondes 12.

Le premier guide d'ondes 12 comporte un premier cœur 22 et une première gaine 24.

Le deuxième guide d'ondes 14 comporte un deuxième cœur 30 et une deuxième gaine 32.

L'indice optique du cœur 22 du premier guide d'ondes 12 est inférieur à l'indice optique de la gaine du deuxième guide d'ondes 14.

Le coupleur optique 10 comprend un troisième guide d'ondes 16 distincts des premier et deuxième guides d'ondes 12, 14 et s'étendant parallèlement aux premier et deuxième guides d'ondes 12, 14.

Le troisième guide d'ondes 16 est agencé entre le premier guide d'ondes 12 et le deuxième guide d'ondes 14 dans une direction transversale perpendiculaire à la direction longitudinale.

Le troisième guide d'ondes 16 présente des paramètres influant sur le couplage par ondes évanescentes entre le premier guide d'ondes 12 et le deuxième guide d'ondes 14, ces paramètres étant choisis de sorte que le couplage C soit supérieur à 15%. Pour rappel, dans le cadre de l'invention, il est choisi d'exprimer le couplage C comme le rapport entre l'intensité du champ électrique de l'onde circulant dans le deuxième guide d'ondes 14 et la somme des intensités des champs électriques de l'onde circulant dans le premier guide d'ondes 12 et le deuxième guide d'ondes 14.

Chaque paramètre caractérisant le troisième guide d'ondes 16 est un paramètre du troisième guide d'ondes 16 influant sur le couplage par ondes évanescentes entre le premier guide d'ondes 12 et le deuxième guide d'ondes 14.

Lorsque le premier guide d'ondes 12 est alimenté en énergie, le premier guide d'ondes 12 émet de la lumière sous forme d'ondes guidées dans le cœur du premier guide d'ondes 12.

Une partie des ondes guidées dans le premier guide d'ondes 12 se couple alors avec le troisième guide d'ondes 16 par des ondes évanescentes. Des ondes sont alors guidées dans le coeur du troisième guide d'ondes 16.

Une partie des ondes guidées dans le troisième guide d'ondes 16 se couple alors avec le deuxième guide d'ondes 14 par des ondes évanescentes. Des ondes sont alors guidées dans le cœur du deuxième guide d'ondes 14.

Le coupleur 10 permet de coupler de la lumière guidée dans le premier guide d'ondes 12 vers le deuxième guide d'ondes 14 via le troisième guide d'ondes 16. Le troisième guide d'ondes 16 sert donc de guide d'ondes intermédiaire.

Le coupleur 10 permet d'éviter le problème de la fuite dans la gaine du deuxième guide d'ondes 14 du mode guidé dans le premier guide d'ondes 12. L'introduction du troisième guide d'ondes 16 empêche une telle fuite. De plus, une telle introduction isole optiquement le deuxième guide d'ondes 14 par rapport à l'environnement extérieur au coupleur 10.

L'emploi du coupleur 10 selon l'invention permet d'obtenir un gain d'un facteur deux en termes de couplage.

Ce meilleur couplage s'obtient tout en conservant une fabrication aisée. En effet, il peut être utilisé un procédé de fabrication avec uniquement des techniques issues de la microélectronique. Un tel procédé de fabrication comprend des étapes de fabrication des différents guides d'ondes impliquant des techniques de dépôt, d'épitaxie, de polissage et d'enlèvement de matière par gravure.

De préférence, les paramètres influant sur le couplage par ondes évanescentes entre le premier guide d'ondes 12 et le deuxième guide d'ondes 14 sont choisis pour que le couplage C soit supérieur à 30%, de préférence supérieur à 50%.

Typiquement, dans le cas où le troisième guide d'ondes 16 comporte une couche supérieure, une couche inférieure et un cœur, le cœur étant situé entre les couches supérieure et inférieure, lesdits paramètres du troisième guide d'ondes 16 influant sur le couplage par ondes évanescentes entre le premier guide d'ondes et le deuxième guide d'ondes sont les dimensions selon deux directions perpendiculaires ainsi que les indices optiques de la couche supérieure, de la couche inférieure et du cœur. En variante, d'autres paramètres sont utilisés pour caractériser le troisième guide d'ondes 16. Notamment, une combinaison linéaire des paramètres précédents est intéressante.

L'augmentation du couplage entre le premier guide d'ondes 12 et le deuxième guide d'ondes 14 par rapport au couplage obtenu dans l'état de la technique est encore plus sensible dans le cas où chaque guide d'ondes 12, 14, 16 comporte une gaine et un cœur, chaque gaine d'un guide d'ondes présentant un indice optique inférieur à l'indice optique du cœur de chaque guide d'ondes 12, 14, 16 adjacent au guide d'ondes 12, 14, 16 de la gaine considérée. En effet, dans ce cas, en l'absence de troisième guide d'ondes 16, le couplage est nul.

De préférence, le premier guide d'ondes 12 est un guide d'ondes actif, c'est-à-dire un guide d'ondes muni d'éléments actifs tandis que le deuxième guide d'ondes 14 est un guide d'ondes passif, soit un guide d'ondes dépourvu d'élément actif. De même, le troisième guide d'ondes 16 est également un guide d'ondes passif.

L'augmentation du couplage entre le premier guide d'ondes 12 et le deuxième guide d'ondes 14 est également obtenue en rendant la dimension du cœur du troisième guide d'ondes 16 variable le long de la direction perpendiculaire à la direction de propagation de la lumière.

De préférence, le deuxième guide d'ondes 14 est à une distance d'au moins 5 millimètres du premier guide d'ondes 12 dans la direction transversale, perpendiculaire à la direction de propagation de la lumière. Cela permet d'isoler le deuxième guide d'ondes 14 de l'environnement du premier guide d'ondes 12.

Le premier guide d'ondes 12 comporte un cœur réalisé dans un matériau appartenant à la colonne III du tableau périodique composé avec un matériau selon la colonne V du tableau périodique et deux couches inférieure et supérieure entourant le cœur. Cette technologie permet de faciliter la réalisation du premier guide d'ondes 12.

Pour augmenter cet effet, le coupleur optique 10 comporte un substrat, formé dans un premier matériau, dans lequel le deuxième guide d'ondes 14 et le troisième guide d'ondes 16 sont enfouis, le premier guide d'ondes 12 étant agencé en contact avec le substrat et formé dans un matériau différent du premier matériau. En effet, dans ce cas, le substrat contribue également à l'isolation du deuxième guide d'ondes 14 par rapport à l'environnement.

Pour augmenter encore plus cet effet, selon une autre variante, le coupleur optique 10 comprend, en outre, un quatrième guide d'ondes distincts des premier, deuxième et troisième guides d'ondes 12, 14, 16 s'étendant parallèlement aux premier, deuxième et troisième guide d'ondes, 12, 14, 16, le quatrième guide d'ondes étant agencé entre le troisième guide d'ondes 16 et le deuxième guide d'ondes 14 et présentant des paramètres influant sur le couplage par ondes évanescentes entre le premier guide d'ondes 12 et le deuxième guide d'ondes 14. L'ensemble des paramètres du troisième guide d'ondes 16 et du quatrième guide d'ondes est alors choisis de sorte que le couplage soit supérieur à 15%.

De préférence, les paramètres du troisième guide d'ondes 16 et du quatrième guide d'ondes influant sur le couplage par ondes évanescentes entre le premier guide d'ondes 12 et le deuxième guide d'ondes 14 sont choisis de sorte que le couplage C soit supérieur à 30%, de préférence supérieur à 50%.

Dans la suite, des modes de réalisation particuliers sont décrits plus précisément. C'est notamment le cas du coupleur optique 10 de la figure 1.

Pour la suite de la description, il est défini une direction longitudinale correspondant à une direction générale de propagation de la lumière. Il est également défini une direction transversale perpendiculaire à la direction longitudinale et contenue dans le plan de la figure 1. Les directions longitudinale et transversale sont respectivement symbolisées par un axe Z et un axe X sur la figure 1. Ainsi, le troisième guide d'ondes 16 est agencé entre le premier guide d'ondes 12 et le deuxième guide d'ondes 14 dans la direction transversale X.

En outre, lorsque le terme « indice » est utilisé pour un milieu, ce terme renvoie à l'indice de réfraction de ce milieu, qui est une grandeur, sans dimension, caractéristique de ce milieu et décrivant le comportement de la lumière dans ce milieu. Dans le cas où le milieu est à gradient d'indice, le terme « indice » renvoie à la moyenne de l'indice dans ce milieu.

Comme indiqué précédemment, on a représenté sur la figure 1 un coupleur optique 10, comportant un premier guide d'ondes 12, un deuxième guide d'ondes 14 et un troisième guide d'ondes 16 agencé entre le premier guide d'ondes 12 et le deuxième guide d'ondes 14 dans la direction transversale X. Le coupleur optique 10 comprend un substrat 18 dans lequel le deuxième guide d'ondes 14 et le troisième guide d'ondes 16 sont enfouis, le premier guide d'ondes 12 reposant sur le substrat 18.

Le coupleur optique 10 est propre à coupler de la lumière du premier guide d'ondes 12 vers le deuxième guide d'ondes 14.

Comme défini précédemment, on appelle « configuration verticale » une configuration dans laquelle le coupleur optique est propre à coupler de la lumière entre deux guides décalés dans la direction transversale X. Par opposition, on appelle « configuration horizontale », une configuration dans laquelle le coupleur optique est propre à coupler de la lumière entre deux guides alignés le long de la direction transversale X. Dans l'exemple de la figure 1, le coupleur optique 10 est dans une configuration verticale.

Le premier guide d'ondes 12 s'étend selon la direction longitudinale Z entre un premier plan d'entrée 12e et un premier plan de sortie 12s. Chaque premier plan 12e et 12s est un plan perpendiculaire à la direction longitudinale Z.

Le premier cœur 22 est formé par une couche s'étendant le long de la direction longitudinale Z. Le premier cœur 22 présente une dimension e22 le long de la direction transversale X de 1,5 micron ($\mu$m) et une dimension I22 le long de la direction longitudinale Z de plusieurs millimètres. Toutefois, sa dimension le long de la direction longitudinale Z le long d'une zone de couplage (définie par le recouvrement avec le deuxième cœur 30) est typiquement de l'ordre de 100 $\mu$m.

Le premier cœur 22 est, par exemple, une hétérostructure formée à partir d'un premier matériau en un mélange composé d'Aluminium (Al), d'Indium (In), et d'Arsenic (As) (de formule AlInAs) et d'un deuxième matériau qui est un mélange composé de Gallium (Ga), d'Indium (In), et d'Arsenic (As) (de formule GaInAs). De ce qui suit, l'indice nc1 du premier cœur 22 vaut 3,3, ce qui se traduit mathématiquement par nc1 = 3,3.

Plus généralement, le premier cœur 22 est dans un matériau à gain, c'est-à-dire un matériau propre à générer de l'émission stimulée de photons suite à une excitation.

La première gaine 24 présente une première couche supérieure 26 et une première couche inférieure 28, le premier cœur 22 étant agencé entre la première couche supérieure 26 et la première couche inférieure 28.

La première couche supérieure 26 présente une dimension e26 le long de la direction transversale X de l'ordre de 1 $\mu$m et une dimension I26 le long de la direction longitudinale Z de l'ordre de 100 $\mu$m.

La première couche inférieure 28 présente une dimension e28 le long de la direction transversale X de l'ordre de 1 $\mu$m et une dimension I28 le long de la direction longitudinale Z de l'ordre de 100 $\mu$m.

Selon l'exemple de la figure 1, la première couche supérieure 26 et la première couche inférieure 28 sont réalisées dans le même matériau. Ce matériau est le matériau dans lequel est réalisée la première gaine 24.

Dans le cas illustré, le matériau est du phosphore d'indium

En variante, la première couche supérieure 26 et la première couche inférieure 28 sont réalisées dans deux matériaux différents.

L'indice ng1 de la première gaine 24 vaut alors 3,1, ce qui se traduit mathématiquement par ng1 = 3,1.

Le premier guide d'ondes 12 forme un guide d'ondes actif. On entend par « guide d'ondes actif » un guide d'ondes comportant au moins une couche formée en matériau actif propre à générer une onde. Dans le cas de la figure 1, le premier cœur 22 est une telle couche.

Plus précisément, le premier guide d'ondes 12 est un guide d'ondes laser, c'est-à-dire une source laser. Le premier guide d'ondes 12 est, par exemple, une source laser dite à cascade quantique (plus souvent désigné par son acronyme anglais de QCL). Un tel guide d'ondes 12 est propre à générer des ondes laser à une longueur d'onde de 4,5 $\mu$m.

Le premier guide d'ondes 12 est propre à propager les ondes selon des mode de propagations correspondant respectivement à un indice effectif. En effet, selon la répartition de champ, chaque mode de propagation voit un indice différent des matériaux constituant le guide d'ondes dépendant de chaque mode de propagation. L'indice vu par chaque mode de propagation définit l'indice effectif.

Le deuxième guide d'ondes 14 s'étend selon la direction longitudinale Z entre un deuxième plan d'entrée 14e et un deuxième plan de sortie 14s. Chaque deuxième plan 14e et 14s est un plan perpendiculaire à la direction longitudinale Z. Le premier plan de sortie 12s est positionné entre le premier plan d'entrée 12e et le deuxième plan d'entrée 14e.

Selon une variante, le deuxième plan d'entrée 14e est positionné entre le premier plan d'entrée 12e et le premier plan de sortie 12s.

Le deuxième cœur 30 est formé par une couche s'étendant le long da la direction longitudinale Z. Le deuxième cœur 30 présente une dimension e30 le long da la direction transversale X de 0,61 $\mu$m et une dimension l22 le long de la direction longitudinale Z de 150 $\mu$m.

Le deuxième cœur 30 est, par exemple, réalisé en silicium-germanium. De ce fait, l'indice nc2 du deuxième cœur 30 vaut 3,6, ce qui se traduit mathématiquement par nc2 = 3,6.

La deuxième gaine 32 comporte une deuxième couche supérieure 34 et une deuxième couche inférieure confondue avec le substrat 18.

En variante, la deuxième gaine 32 comprend une deuxième couche inférieure distincte du substrat 18.

La deuxième couche supérieure 34 présente une dimension e34 le long de la direction transversale X de l'ordre de 1 $\mu$m et une dimension l34 le long de la direction longitudinale Z de l'ordre de 100 $\mu$m.

La deuxième gaine 32 est, par exemple, réalisée en silicium. L'indice ng2 de la deuxième gaine 32 vaut alors 3,4, ce qui se traduit mathématiquement par ng2 = 3,4.

Le deuxième guide d'ondes 14 est un guide d'ondes passif, c'est-à-dire un guide d'ondes ne comportant pas de couche formé dans un matériau actif.

Le deuxième guide d'ondes 14 est enfoui dans le substrat 18, c'est-à-dire qu'il est isolé optiquement du milieu environnant. Par exemple, le deuxième guide d'ondes 14 est agencé à une distance de 5 mm du premier guide d'ondes 12 le long de la direction transversale X. Le deuxième guide d'ondes 14 est propre à permettre la propagation de modes de propagation correspondant chacun à un indice effectif.

Le substrat 18 est formé par une couche s'étendant le long de la direction longitudinale Z s'étendant entre un plan d'entrée 18e et un plan de sortie 18f. Selon l'exemple de la figure 1, le plan de sortie 18f du substrat 18 est confondu avec le deuxième plan de sortie 14s tandis que le premier plan d'entrée 12e est entre le plan d'entrée 18e du substrat 18 et le premier plan de sortie 12s.

Le substrat 18 présente une dimension e18 le long de la direction transversale de quelques microns et une dimension l18 le long de la direction longitudinale Z de l'ordre de la centaine de microns.

Le substrat 18 est, par exemple, réalisé en silicium. L'indice ns18 du substrat 18 vaut alors 3,4, ce qui se traduit mathématiquement par ns18 = 3,4.

Le matériau du substrat 18 est différent des matériaux des différentes couches (première couche supérieure 26, première couche inférieure 28 et premier cœur 22) du premier guide d'ondes 12. De ce fait, on parle d'une intégration hétérogène du premier guide d'ondes 12 sur le substrat 18.

Le troisième guide d'ondes 16 s'étend selon la direction longitudinale Z entre un troisième plan d'entrée 16e et un troisième plan de sortie 16s. Chaque troisième plan 16e et 16s est un plan perpendiculaire à la direction longitudinale Z. Le troisième plan d'entrée 16e est positionné entre le plan d'entrée 18e du substrat 18 et le premier plan d'entrée 12e. Le troisième plan de sortie 16s est positionné entre le deuxième plan d'entrée 14e et le deuxième plan de sortie 14s.

En variante, le troisième plan d'entrée 16e est positionné entre le premier plan d'entrée 12e et le premier plan de sortie 16s.

En outre, le troisième guide d'ondes 16 est agencé entre le premier guide d'ondes 12 et le deuxième guide d'ondes 14. Ainsi, il peut être considéré que le troisième guide d'ondes est adjacent d'une part au premier guide d'ondes 12 et adjacent d'autre part au deuxième guide d'ondes 14.

Le troisième guide d'ondes 16 comporte un troisième cœur 36 et une troisième gaine 38.

Le troisième cœur 36 est formé par une couche s'étendant le long de la direction longitudinale Z. Le troisième cœur 36 présente une dimension e36 le long de la direction transversale X et une dimension l36 le long de la direction longitudinale Z.

Le troisième cœur 26 est réalisé dans un matériau présentant un indice noté nc3. La troisième gaine 38 présente une troisième couche supérieure 40 et une troisième couche inférieure 42, le troisième cœur 36 étant agencé entre la troisième couche supérieure 40 et la troisième couche inférieure 42.

Ainsi, la troisième couche supérieure 40 est agencée entre la première couche inférieure 22 et le troisième cœur 36.

La troisième couche supérieure 40 présente une dimension e40 le long de la direction transversale X et une dimension l40 le long de la direction longitudinale Z.

La troisième couche supérieure 40 est réalisée dans un matériau présentant un indice noté n40.

La troisième couche inférieure 42 est agencée entre le troisième cœur 36 et la deuxième couche supérieure 34.

La troisième couche inférieure 42 présente une dimension e42 le long de la direction transversale X et une dimension l42 le long de la direction longitudinale Z.

La troisième couche inférieure 42 est réalisée dans un matériau présentant un indice noté n42.

Le troisième guide d'ondes 16 est un guide d'ondes passif. Le troisième guide d'ondes 14 est ainsi propre à permettre la propagation de modes de propagation correspondant chacun à un indice effectif.

Il apparaît que le troisième guide d'ondes 16 est caractérisé par une pluralité de paramètres qui sont pour chacune des trois couches (troisième cœur 26, couche supérieure 40 et couche inférieure 42) la dimension de la couche considérée le long de la direction longitudinale Z, la dimension de la couche considérée le long de la direction transversale X et l'indice dans lequel est réalisé la couche considérée. Les paramètres qui caractérisent le troisième guide d'ondes 16 sont des paramètres influençant le couplage entre le premier guide d'ondes 12 et le deuxième guide d'ondes 14.

En variante, d'autres paramètres sont utilisés pour caractériser le troisième guide d'ondes 16. Notamment, une combinaison linéaire des paramètres de dimension de la couche considérée le long de la direction longitudinale Z et de dimension de la couche considérée le long de la direction transversale X est intéressante.

A titre d'exemple, au lieu d'utiliser les dimensions précités, il est utilisé les distances d1 et d2 respectivement définies comme la distance entre le premier guide d'ondes 12 et le deuxième guide d'ondes 14 dans la direction transversale X et la distance entre le premier guides d'ondes 12 et le troisième guide d'ondes 16 dans la direction transversale X. Par exemple, la distance entre deux guides d'ondes dans la direction transversale X est la distance entre les cœurs des guides d'ondes dans la direction transversale X. La distance entre le troisième plan d'entrée 16e et le premier plan d'entrée 12e dans la direction longitudinale Z ou la distance entre le troisième plan de sortie 16s et le deuxième plan d'entrée 14e dans la direction longitudinale Z sont d'autres exemples de paramètres pouvant être pris en compte. Selon l'invention, les paramètres caractérisant le troisième guide d'ondes 16 vérifient une première propriété notée P1. La première propriété P1 est vérifiée lorsque le couplage par ondes évanescentes entre le premier guide d'ondes 12 et le deuxième guide d'ondes 14 est supérieur à 15%. Pour rappel, dans le cadre de l'invention, il est choisi d'exprimer le couplage comme le rapport entre l'intensité du champ électrique de l'onde circulant dans le deuxième guide d'ondes 14 et la somme des intensités des champs électriques de l'onde circulant dans le premier guide d'ondes 12 le deuxième guide d'ondes 14.. Dans la suite, le couplage ainsi défini est noté « C » qui est un nombre sans unité.

De manière connue en soi, pour un couplage par ondes évanescentes imposé, l'homme du métier est capable de déterminer les paramètres manquants du coupleur 10 qui sont à choisir. En effet, le transfert de la lumière d'un guide d'ondes à un autre guide d'ondes implique que les modes de propagation guidés de chaque guide soient suffisamment proches l'un de l'autre pour que leur partie évanescente ait un recouvrement non nul. La longueur optimale de couplage est alors fonction de ce recouvrement qui lui-même dépend des caractéristiques opto-géométriques des guides d'ondes considérés.

Par exemple, il est connu du livre intitulé Optical wave guide theory de A.W Sneider et J.D. Love publié chez Chapman and Hall, en 1983 que, pour deux guides d'ondes A et B suffisamment proches pour que la partie évanescente des modes de propagation des ondes circulant dans ces deux guides se recouvre, la longueur $L_C$ correspondant au couplage maximal depuis le guide d'ondes A vers le guide d'ondes B à l'autre peut s'écrire :

$$Lc = \frac{\pi}{\sqrt{K^2 + \delta^2}}$$

Où :

•
$$\delta = \frac{\pi}{\lambda}\left(n_{effA} - n_{effB}\right)$$

o*ù

○ A est la longueur dans le vide,
○ $n_{effA}$ est l'indice effectif du mode de propagation considéré circulant dans le guide d'ondes A , et
○ $n_{effB}$ est l'indice effectif du mode de propagation considéré circulant dans le guide d'ondes B,

•
$$K = \sqrt{\frac{\varepsilon_0}{\mu_0}} \frac{k}{4} \int_{S_B} \Delta(n^2) E_a E_b^* dA \quad \text{où}$$

où

○ $\varepsilon_0$ est la perméabilité diélectrique dans le vide,
○ $\mu_0$ est la perméabilité magnétique dans le vide,
○ k est le nombre d'ondes associé à la longueur d'onde $\lambda$,
○ $\Delta(n^2)$ est la différence d'indice au carré entre l'indice du cœur du guide d'ondes B et l'indice de la gaine du guide d'ondes A,
○ $E_a$ est le champ électrique du mode de propagation considéré dans le guide d'ondes A,
○ $E_b$ est le champ électrique du mode de propagation considéré dans le guide d'ondes B,
○ « * » désigne l'opération mathématique de conjugaison, et
○ $S_B$ est la section du cœur du guide d'ondes B.

Pour effectuer les calculs, l'homme du métier a usuellement recours à des outils de simulation numérique notamment pour calculer les champs des modes de propagation des guides d'ondes A et B.

Pour parvenir à déterminer les différents paramètres dans le cadre de l'invention, il convient d'utiliser la formule précédente pour optimiser d'une part le couplage entre le premier guide d'ondes 12 et le troisième guide d'ondes 14 et d'autre part le couplage entre le troisième guide d'ondes 14 et le premier guide d'ondes 12. Les détails des équations associés à cette double optimisation ne sont pas présentés davantage, sachant que l'homme du métier est capable d'étendre le concept proposé pour deux guides d'ondes A et B aux trois guides d'ondes 12, 14, 16 du coupleur 10.

La mise en œuvre d'une telle optimisation conduit, dans le cas de la figure 1, par exemple, au choix suivant.

Le troisième cœur 36 est, par exemple, réalisé en germanium. De ce fait, l'indice nc3 du troisième cœur 36 est égal à 4,0, ce qui se traduit mathématiquement par nc3 = 4,0.

La dimension e36 le long de la direction transversale X du troisième cœur 30 est de 0,4 μm et la dimension l36 le long de la direction longitudinale Z du troisième cœur 30 est de l'ordre de la centaine de microns.

Les deux troisièmes couches supérieure 40 et inférieure 42 sont réalisées dans un même matériau, en l'occurrence du sulfure de zinc. L'indice n40 de la couche supérieure 40 est donc égale à l'indice n42 de la couche inférieure 42, ce qui se traduit mathématiquement par n40 = n42 = 2,2. La valeur de 2,2 correspond à l'indice du sulfure de zinc.

La dimension e40 le long de la direction transversale X et la dimension l40 le long de la direction longitudinale Z de la troisième couche supérieure 40 sont respectivement de l'ordre du micron et de l'ordre de la centaine de microns.

La dimension e42 le long de la direction transversale X et la dimension l42 le long de la direction longitudinale Z de la troisième couche inférieure 42 sont respectivement de l'ordre du micron et de l'ordre de la centaine de microns.

Le fonctionnement du coupleur optique 10 selon l'invention est maintenant décrit

Lorsque le premier guide d'ondes 12 est alimenté en énergie, le premier guide d'ondes 12 émet de la lumière sous forme d'ondes guidées dans le premier cœur 22.

Une partie des ondes guidées dans le premier cœur 22 se couple alors avec le troisième guide d'ondes 16 par des ondes évanescentes. Des ondes sont alors guidées dans le troisième cœur 36.

Une partie des ondes guidées dans le troisième cœur 36 se couple alors avec le deuxième guide d'ondes 14 par des ondes évanescentes. Des ondes sont alors guidées dans le deuxième cœur 30.

Le coupleur 10 permet de coupler de la lumière guidée dans le premier cœur 22 vers le deuxième cœur 30 via le troisième guide d'ondes 16. Le troisième guide d'ondes sert donc de guide d'ondes intermédiaire.

Les figures 2 et 3 sont des simulations montrant la répartition de l'énergie lumineuse dans le coupleur optique 10 selon la figure 1. A l'observation de la figure 3, il apparaît qu'au plan d'entrée 12e du premier guide d'ondes 12, l'intensité du champ électrique est de 100% alors qu'au plan de sortie 14s du deuxième guide d'ondes 14, l'intensité du champ électrique est de 20%, ce qui montre que le couplage C est de l'ordre de 20%.

Ceci montre que les paramètres choisis pour le coupleur 10 de la figure 1, c'est-à-dire pour chacune des trois couches (troisième cœur 26, couche supérieure 40 et couche inférieure 42) la dimension le long de la direction longitudinale Z de la couche considérée, la dimension le long de la direction transversale X de la couche considérée et l'indice optique dans lequel est réalisé la couche considérée, vérifient la propriété P1.

Le couplage C obtenu en étudiant la figure 3 est à comparer au couplage obtenu avec un coupleur optique selon l'état de la technique.

Un tel coupleur optique selon l'état de la technique est un coupleur dépourvu de troisième guide d'ondes intermédiaire.

Dans ce cas, les figures 4 et 5 sont obtenues par simulation. A l'étude de la figure 5, il est constaté que le couplage C est faible, de l'ordre de 10%. Autrement formulé, l'emploi du coupleur 10 selon l'invention permet d'obtenir un gain d'un facteur deux en termes de couplage.

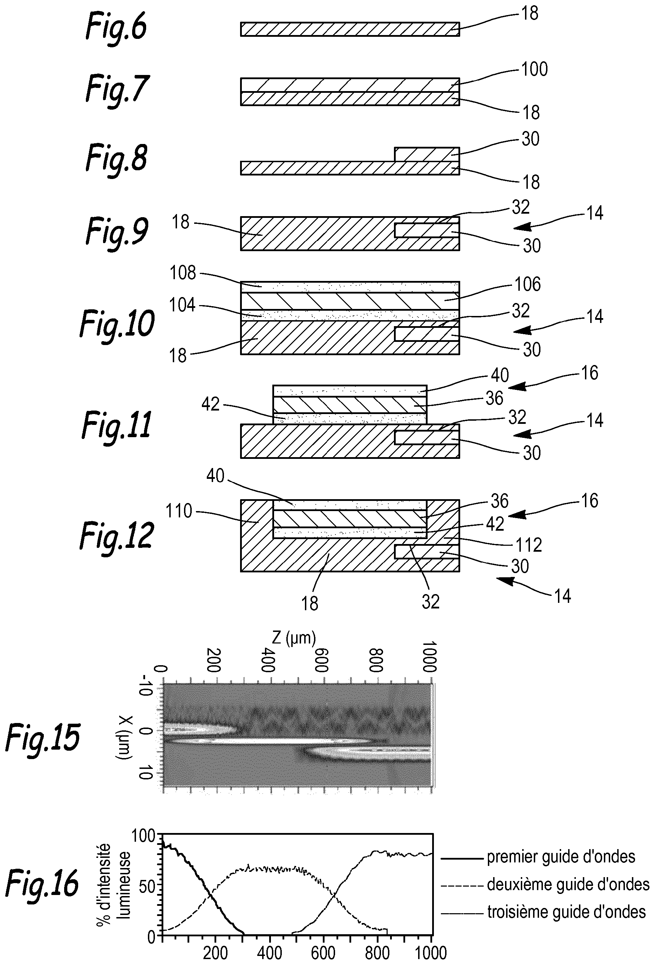

Ce meilleur couplage s'obtient tout en conservant une fabrication aisée. Pour illustrer cet avantage, il est maintenant décrit en référence aux figures 6 à 13.

Ainsi que cela apparaît à l'étude des valeurs de l'exemple de la figure 1, en l'absence du troisième guide d'ondes 14, comme l'indice ng2 de la deuxième gaine est supérieur à l'indice nc1 du premier cœur 20, le couplage est physiquement impossible. L'introduction du troisième guide d'ondes 14 permet que, pour chaque guide d'ondes, l'indice de la gaine du guide d'ondes soit inférieur aux indices du ou des cœurs de chaque guide d'ondes adjacent.

Le procédé de fabrication comporte, dans un premier temps, le dépôt d'un substrat 18 en silicium. Par exemple, l'étape de dépôt 102 est, par exemple, mise en œuvre par une technique connue en soi de dépôt en phase vapeur chimique (souvent appelée CVD pour Chemical Vapor Déposition) ou physique en phase vapeur (souvent appelée PVD pour Physical Vapor Déposition). La couche de substrat 18 obtenue est illustrée schématiquement à la figure 6.

Le procédé de fabrication comporte ensuite la fabrication d'une couche 100 en silicium et germanium sur le substrat 18 en silicium. Selon l'exemple proposé, la fabrication est mise en œuvre par réalisation d'une épitaxie de silicium et de germanium cristallin. L'épitaxie est une technique de croissance orientée, l'un par rapport à l'autre, de deux matériaux (en l'occurrence le silicium et le germanium) possédant un certain nombre d'éléments de symétrie communs dans leurs réseaux cristallins. L'ensemble de la couche de substrat 18 et de la couche 100 en silicium et germanium obtenu à l'issue de cette étape du procédé est illustré schématiquement à la figure 7.

Le procédé comprend ensuite une étape de lithogravure réalisée dans la couche de silicium-germanium de manière à découper une partie de la couche 100 pour obtenir une couche formant le deuxième cœur 30 du deuxième guide d'ondes 14. L'ensemble de la couche de substrat 18 et du deuxième cœur 30 obtenu à l'issue de cette étape du procédé est illustrée schématiquement à la figure 8.

Le procédé comporte après une étape de fabrication d'une couche en silicium de manière à former le substrat 18 (le substrat étant le support mécanique de base sur lequel on dépose les couches minces) et la couche supérieure 32 du deuxième guide d'ondes 14. Cette étape de fabrication comporte successivement une étape d'épitaxie de la couche et une étape de polissage de la couche. Selon l'exemple de procédé illustré, l'étape de polissage est mise en œuvre à l'aide d'une technique de polissage mécano-chimique, plus souvent désignée par son acronyme CMP pour l'anglais « Chemical Mechanical Polishing. L'ensemble du substrat 18 et du deuxième guide d'ondes 14 obtenu à l'issue de cette étape du procédé est illustrée schématiquement à la figure 9.

Le procédé comprend ensuite une étape de dépôt permettant de former un ensemble 102 de trois couches destiné à former le troisième guide d'ondes 16. L'ensemble 102 de trois couches comprend une première couche 104 destinée à former la troisième couche inférieure 42, une deuxième couche 106 destinée à former le troisième cœur 36 et une troisième couche 108 destinée à former la troisième couche supérieure 40. L'étape de dépôt comprend d'abord le dépôt de la première couche 104 en sulfure de zinc sur l'ensemble du substrat 18 et du deuxième guide d'ondes 14, puis le dépôt de la deuxième couche 106 en germanium sur la première couche 104 et enfin le dépôt de la troisième couche 108 en sulfure de zinc sur la deuxième couche 106. L'ensemble du substrat 18, du deuxième guide d'ondes 14 avec l'ensemble 102 de trois couches 104, 106, 108 obtenu à l'issue de cette étape du procédé est illustré schématiquement à la figure 10.

Le procédé comprend ensuite une étape de lithogravure réalisée dans l'ensemble 102 de trois couches 104, 106, 108 de manière à découper une partie des trois couches 104, 106, 108 pour obtenir le troisième guide d'ondes 16. L'étape de lithogravure permet de dimensionner l'ensemble 102 à la taille souhaitée pour le troisième guide d'ondes 16. L'ensemble du substrat 18, du deuxième guide d'ondes 14 et du troisième guide d'ondes 16 obtenu à l'issue de cette étape du procédé est représenté à la figure 11.

Le procédé comporte ensuite une étape de fabrication de parties 110, 112 en silicium de part et d'autre du troisième guide d'ondes 16, de manière à enfouir le deuxième guide d'ondes 14 dans le substrat 18. Cette étape de fabrication comporte successivement une étape d'épitaxie des parties 110, 112 et une étape de polissage des parties 110, 112 et de la troisième partie supérieure 40. Selon l'exemple de procédé illustré, l'étape de polissage est mise en œuvre à l'aide d'une technique CMP. L'ensemble du substrat 18, du deuxième guide d'ondes 14 et du troisième guide d'ondes 16 obtenu à l'issue de cette étape du procédé est représenté à la figure 12.

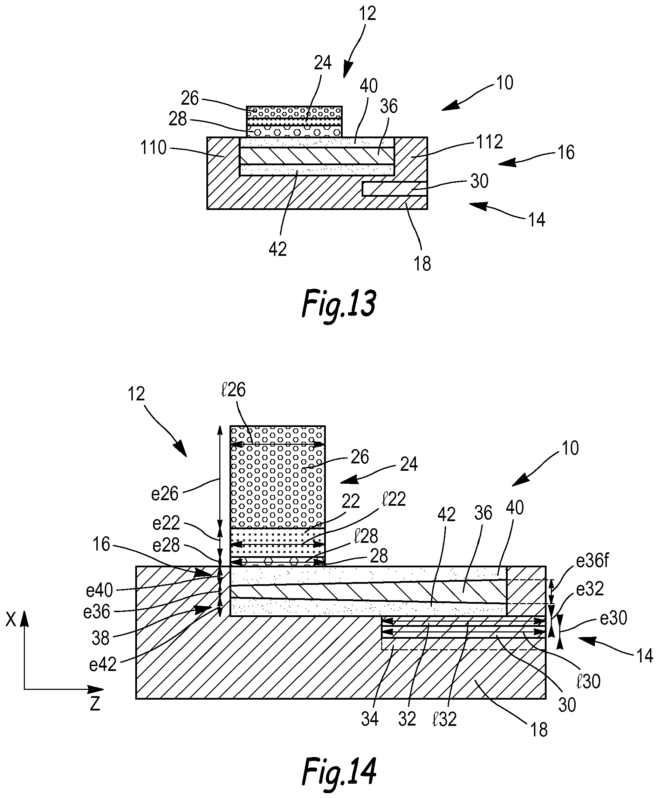

Le procédé comporte enfin une étape de collage du premier guide d'ondes 12, dont le résultat est illustré par la figure 13. L'étape de collage pourra être un collage par adhésion moléculaire. On peut aussi réaliser un collage de l'épitaxie simple (couches minces), puis réalisation du guide d'ondes 12 par les techniques semblables à celles utilisées pour le guide d'ondes 14.

Le procédé permet donc d'obtenir le coupleur optique 10. La mise en œuvre de ce procédé implique uniquement des technologies éprouvées dans le cadre de la fabrication des composants planaires, et plus particulièrement les composants en matériau semi-conducteur. Notamment, un tel procédé de fabrication n'implique pas la mise en œuvre d'une technologie d'immersion dans des bains de sels fondus qui est une technologie délicate à mettre en œuvre. De ce fait, le procédé selon l'invention est particulièrement aisé à mettre en œuvre.

En outre, le coupleur optique 10 présente l'avantage de ne pas imposer de contraintes sur la forme du premier guide d'ondes 12 et du deuxième guide d'ondes 14. Le premier guide d'ondes 12 et le deuxième guide d'ondes 14 peuvent donc être optimisés pour fournir un rendement optimal (rapport entre la puissance en sortie du dispositif considéré et la puissance incidente sur le dispositif considéré) sans dégrader le couplage C.

En variante, il est à noter qu'il est possible de concevoir de multiples coupleurs optiques 10 dont les paramètres du troisième guide d'ondes 16 vérifient la propriété P1 relative au couplage C. Ces coupleurs réduisent également les fuites dans la gaine du deuxième guide d'ondes du mode guidé dans le premier cœur 22.

Notamment, différents matériaux sont envisageables pour réaliser le troisième cœur 36, la troisième couche supérieure 40 et la troisième couche inférieure 42. En particulier, des matériaux semi-conducteurs de type « III - V » sont envisageables.

Un critère pour choisir les matériaux peut aussi être la facilité de fabrication. Par exemple, il est plus aisé de réaliser le troisième cœur 36 en germanium.

Ces remarques sur les matériaux s'appliquent aux matériaux de toutes les couches intervenant dans le coupleur 10.

En outre, des formes différentes sont envisageables pour les couches 36, 40, 42 formant le troisième guide d'ondes 16.

C'est notamment le cas pour le coupleur 10 selon un deuxième mode de réalisation décrit en référence à la figure 14.

Les éléments identiques entre le coupleur 10 selon le deuxième mode de réalisation et le coupleur 10 selon le premier mode de réalisation ne sont pas répétés. Seules les différentes sont mises en évidence.

Dans le cas de la figure 14, le troisième cœur 36 présente une dimension le long de la direction transversale X croissante lorsque le troisième cœur 36 est parcouru le long de la direction longitudinale Z.

Selon ce deuxième mode de réalisation, la croissance est linéaire entre une valeur initiale e36i et une valeur finale e36f. La valeur initiale e36i est la valeur de la dimension le long de la direction transversale X du troisième cœur 36 au niveau d'une première extrémité du troisième cœur 36 tandis que la valeur finale e36f est la valeur de la dimension le long de la direction transversale X du troisième cœur 36 au niveau d'une deuxième extrémité du troisième cœur 36. Dans ce cas particulier, la valeur initiale e36i est égale à 0,4 $\mu$m et la valeur finale e36f est égale à 0,61 $\mu$m.

D'autres variations de la dimension le long de la direction transversale X qu'une variation linéaire sont envisageables, une variation linéaire présentant toutefois l'avantage d'être simple à réaliser avec les technologies planaires de fabrication connues de l'état de la technique.

Les figures 15 et 16 sont des simulations montrant la répartition de l'énergie lumineuse dans le coupleur optique 10 selon la figure 14. A l'observation de la figure 16, il apparaît que l'intensité du champ électrique est de 100% dans le plan d'entrée 12e du premier guide d'ondes 12 alors que dans le plan de sortie 14s du deuxième guide d'ondes 14, l'intensité du champ électrique est de 80%, ce qui montre que le couplage C est de l'ordre de 80%. Ceci correspond à un gain d'un facteur 8 en intensité dans le deuxième guide d'ondes 14 par rapport à l'état de la technique.

Cet exemple montre également que de préférence, pour obtenir le meilleur couplage, les paramètres caractérisant le troisième guide d'ondes 16 vérifient, en variante, une deuxième propriété notée P2. La deuxième propriété P2 est vérifiée lorsque le couplage C par ondes évanescentes entre le premier guide d'ondes 12 et le deuxième guide d'ondes 14 est supérieur à 30%.

Encore plus avantageusement, en variante, les paramètres caractérisant le troisième guide d'ondes 16 vérifient une troisième propriété notée P3. La troisième propriété P3 est vérifiée lorsque le couplage C par ondes évanescentes entre le premier guide d'ondes 12 et le deuxième guide d'ondes 14 est supérieur à 50%.

Selon d'autres variantes, il est également possible de considérer des structures plus complexes. A titre d'exemple, le coupleur optique 10 comporte une pluralité de guides d'ondes intermédiaires. Dans ce cas, c'est l'ensemble des paramètres caractérisant les guides d'ondes intermédiaires qui sont tels que le couplage par ondes évanescentes entre le premier guide d'ondes 12 et le deuxième guide d'ondes 14 soit supérieur à 15% (respectivement 30%, 50% selon la propriété choisie). Des guides d'ondes 12, 14 et 16 munis de moyens d'adaptation d'indice effectif peuvent également être considérés.

Du fait de la multiplicité des coupleurs optiques 10 répondant aux propriétés P1, P2 ou P3, il est également proposé, dans le cadre de cette invention, un procédé de détermination des paramètres comportant une étape de choix des paramètres de sorte que le couplage C soit supérieur à 15%, 30% ou 50%.

Le coupleur optique 10 obtenu est notamment particulièrement intéressant dans le cas d'un capteur de gaz intégrés. Plus généralement, un tel coupleur optique 10 peut être utilisé dans tout composant optique pour lequel il est favorable de mettre en œuvre une intégration hétérogène.

Il est aussi à noter que le coupleur optique 10 trouve également des applications dans le cas où le premier guide d'ondes 12 n'est pas un guide d'ondes actif. A titre d'exemple, le premier guide d'ondes 12 est un détecteur infrarouge comprenant un matériau absorbant à la longueur d'onde d'intérêt avec une couche de matériau transparent à cette même longueur d'onde d'intérêt. Dans le domaine des télécommunications où la puce optique sert à faire du traitement de signal optique (par exemple démultiplexage, etc...), il peut être intéressant d'intégrer les détecteurs directement sur la puce pour plus de compacité.

## Revendications

1. Coupleur optique (10) dans une configuration verticale comprenant :

   - un premier guide d'ondes (12) s'étendant selon une direction longitudinale (Z), le premier guide d'ondes (12) comportant un premier cœur (22) et une première gaine (24) présentant chacun un indice optique (nc1, ng1), le premier cœur (20) étant réalisé dans un matériau appartenant à la colonne III du tableau périodique composé avec un matériau selon la colonne V du tableau périodique, et
   - un deuxième guide d'ondes (14) distinct du premier guide d'ondes (12), s'étendant parallèlement au premier guide d'ondes (12), le deuxième guide d'ondes (14) comportant un deuxième cœur (30) et une deuxième gaine (32),

   le coupleur optique (10) comprenant, en outre :

   - un troisième guide d'ondes (16) distincts des premier et deuxième guides d'ondes (12, 14) et s'étendant parallèlement aux premier et deuxième guides d'ondes (12, 14), le troisième guide d'ondes (16) étant agencé entre le premier guide d'ondes (12) et le deuxième guide d'ondes (14) dans une direction transversale (X) perpendiculaire à la direction longitudinale (Z) et présentant des paramètres influant sur le couplage par ondes évanescentes entre le premier guide d'ondes (12) et le deuxième guide d'ondes (14), ces paramètres étant choisis de sorte que le couplage (C) soit supérieur à 15%, le troisième guide d'ondes (16) comportant une couche supérieure (40), une couche inférieure (42) et un troisième cœur (36), lesdits paramètres du troisième guide d'ondes (16) influant sur le couplage par ondes évanescentes entre le premier guide d'ondes (12) et le deuxième guide d'ondes (14) étant les dimensions selon deux directions perpendiculaires ainsi que les indices optiques de la couche supérieure (40), de la couche inférieure (42) et du troisième cœur (36), et

le coupleur optique (10) comportant un substrat (18), formé dans un premier matériau de préférence du silicium, dans lequel le deuxième guide d'ondes (14) et le troisième guide d'ondes (16) sont enfouis, le premier guide d'ondes (12) étant agencé en contact avec le substrat (18) et formé dans un matériau différent du premier matériau; **caractérisé en ce que** le deuxième cœur et la deuxième gaine présentent un indice optique (nc2, ng2), l'indice optique (nc1) du premier cœur du premier guide d'ondes étant inférieur à l'indice optique (ng2) de la deuxième gaine du deuxième guide d'ondes.

2. Coupleur optique selon la revendication 1, dans lequel lesdits paramètres du troisième guide d'ondes (16) influant sur le couplage par ondes évanescentes entre le premier guide d'ondes (12) et le deuxième guide d'ondes (14) sont choisis de sorte que le couplage (C) soit supérieur à 30%, de préférence supérieur à 50%.

3. Coupleur optique selon la revendication 1 ou 2, dans lequel le troisième guide d'ondes (16) comporte une troisième gaine (38) comprenant ladite couche inférieure et ladite couche supérieure, chaque gaine (24, 32, 38) d'un guide d'ondes (12, 14, 16) présentant un indice optique inférieur à l'indice optique du cœur (20, 30, 36) de chaque guide d'ondes (12, 14, 16) adjacent au guide d'ondes (12, 14, 16) de la gaine (24, 32, 38) considérée.

4. Coupleur optique selon l'une quelconque des revendications 1 à 3, dans lequel le premier guide d'ondes (12) est un guide d'ondes actif et les deuxième et troisième guides d'ondes (14, 16) sont des guides d'ondes passif.

5. Coupleur optique selon l'une quelconque des revendications 1 à 6, dans lequel le premier guide d'ondes (12) comporte deux couches inférieure (26) et supérieure (28) entourant le premier cœur (20).

6. Coupleur optique selon l'une quelconque des revendications 1 à 5, dans lequel le troisième cœur (36) du troisième guide d'ondes (16) a une dimension variable le long de la direction transversale (X).

7. Coupleur optique selon l'une quelconque des revendications 1 à 6, dans lequel le deuxième guide d'ondes (14) est à une distance d'au moins 5 millimètres du premier guide d'ondes (12) dans la direction transversale (X).

8. Coupleur optique selon l'une quelconque des revendications 1 à 7, dans lequel le coupleur optique (10) comprend, en outre, un quatrième guide d'ondes distincts des premier, deuxième et troisième guides d'ondes (12, 14, 16) et s'étendant parallèlement aux premier, deuxième et troisième guide d'ondes (12, 14, 16), le quatrième guide d'ondes étant agencé entre le troisième guide d'ondes (12) et le deuxième guide d'ondes (14) et présentant des paramètres influant sur le couplage par ondes évanescentes entre le premier guide d'ondes (12) et le deuxième guide d'ondes (14),
l'ensemble des paramètres du troisième guide d'ondes (16) et du quatrième guide d'ondes étant choisis de sorte que le couplage (C) soit supérieur à 15%.

9. Coupleur optique (10) selon la revendication 8, dans lequel les paramètres du troisième guide d'ondes (16) et du quatrième guide d'ondes influant sur le couplage par ondes évanescentes entre le premier guide d'ondes (12) et le deuxième guide d'ondes (14) sont choisis de sorte que le couplage (C) soit supérieur à 30%, de préférence supérieur à 50%.

10. Composant optique comprenant un coupleur optique (10) selon l'une quelconque des revendications 1 à 9.

11. Procédé de détermination de paramètres d'un coupleur optique (10) dans une configuration verticale comprenant :

     - un premier guide d'ondes (12) s'étendant selon une direction longitudinale (Z), le premier guide d'ondes (12) comportant un premier cœur (22) et une première gaine (24) présentant chacun un indice optique (nc1, ng1), le premier cœur (20) étant réalisé dans un matériau appartenant à la colonne III du tableau périodique composé avec un matériau selon la colonne V du tableau périodique, et
     - un deuxième guide d'ondes (14) distinct du premier guide d'ondes (12) et s'étendant parallèlement au premier guide d'ondes (12), le deuxième guide d'ondes (14) comportant un deuxième cœur (30) et une deuxième gaine (32) présentant un indice optique (nc2, ng2), l'indice optique (nc1) du premier cœur (20) du premier guide d'ondes (12) étant inférieur à l'indice optique (nc2) de la deuxième gaine (ng2) du deuxième guide d'ondes (14),
     - un troisième guide d'ondes (16) distincts des premier et deuxième guides d'ondes (12, 14) et s'étendant parallèlement aux premier et deuxième guides d'ondes (12, 14), le troisième guide d'ondes (16) étant agencé entre le premier guide d'ondes (12) et le deuxième guide d'ondes (14) dans une direction transversale (X) perpendiculaire à la direction longitudinale (Z) et présentant des paramètres influant sur le couplage par ondes évanescentes entre le premier guide d'ondes (12) et le deuxième guide d'ondes (14), le troisième guide d'ondes (16) comportant une couche supérieure (40), une couche inférieure (42) et un troisième cœur (36), lesdits paramètres du troisième guide d'ondes (16) influant sur le couplage par ondes évanescentes entre le premier guide d'ondes (12) et le deuxième guide d'ondes (14) étant les dimensions selon deux directions perpendiculaires ainsi que les indices optiques de la couche supérieure (40), de la couche inférieure (42) et du troisième cœur (36),

le coupleur optique (10) comportant un substrat (18), formé dans un premier matériau de préférence du silicium, dans lequel le deuxième guide d'ondes (14) et le troisième guide d'ondes (16) sont enfouis, le premier guide d'ondes (12) étant agencé en contact avec le substrat (18) et formé dans un matériau différent du premier matériau

le procédé de détermination comportant une étape de choix des paramètres de sorte que le couplage (C) soit supérieur à 15%.

12. Procédé de fabrication d'un coupleur optique (10) selon l'une quelconque des revendications 1 à 9, dans lequel le procédé de fabrication comprend des étapes de fabrication des différents guides d'ondes impliquant des techniques de dépôt, d'épitaxie, de polissage et d'enlèvement de matière par gravure.

**Patentansprüche**

1. Optischer Koppler (10) in einer vertikalen Konfiguration, umfassend:

- einen ersten Wellenleiter (12), der sich gemäß einer Längsrichtung (Z) erstreckt, wobei der erste Wellenleiter (12) einen ersten Kern (22) und einen ersten Mantel (24) umfasst, die jeweils einen Brechungsindex (nc1, ng1) aufweisen, wobei der erste Kern (20) aus einem Material hergestellt ist, das zu der Spalte III des Periodensystems gehört, zusammengesetzt mit einem Material gemäß der Spalte V des Periodensystems, und
- einen zweiten Wellenleiter (14), unterschiedlich zum ersten Wellenleiter (12), der sich parallel zum ersten Wellenleiter (12) erstreckt, wobei der zweite Wellenleiter (14) einen zweiten Kern (30) und einen zweiten Mantel (32) aufweist,

wobei der optische Koppler (10) außerdem umfasst:

- einen dritten Wellenleiter (16), unterschiedlich zu dem ersten und zweiten Wellenleiter (12, 14) und sich parallel zu dem ersten und zweiten Wellenleiter (12, 14) erstreckend, wobei der dritte Wellenleiter (16) zwischen dem ersten Wellenleiter (12) und dem zweiten Wellenleiter (14) in einer Querrichtung (X) senkrecht zur Längsrichtung (Z) angeordnet ist und Parameter aufweist, die die Kopplung durch evaneszente Wellen zwischen dem ersten Wellenleiter (12) und dem zweiten Wellenleiter (14) beeinflussen, wobei diese Parameter so gewählt sind, dass die Kopplung (C) größer als 15 % ist, wobei der dritte Wellenleiter (16) eine obere Schicht (40), eine untere Schicht (42) und einen dritten Kern (36) aufweist, wobei die Parameter des dritten Wellenleiters (16), die die Kopplung durch evaneszente Wellen zwischen dem ersten Wellenleiter (12) und dem zweiten Wellenleiter (14) beeinflussen, die Abmessungen gemäß zwei senkrechte Richtungen sowie die Brechungsindices der oberen Schicht (40), der unteren Schicht (42) und des dritten Kerns (36) sind, und

der optische Koppler (10) ein Substrat (18) aufweist, das in einem ersten Material, vorzugsweise Silizium, hergestellt ist, in dem der zweite Wellenleiter (14) und der dritte Wellenleiter (16) vergraben sind, wobei der erste Wellenleiter (12) in Kontakt mit dem Substrat (18) angeordnet ist und aus einem Material unterschiedlich zu dem ersten Material gebildet ist;
**dadurch gekennzeichnet, dass**
der zweite Kern und der zweite Mantel einen Brechungsindex (nc2, ng2) aufweisen, wobei der Brechungsindex (nc1) des ersten Kerns des ersten Wellenleiters kleiner als der Brechungsindex (ng2) des zweiten Mantels des zweiten Wellenleiter ist.

2. Optischer Koppler nach Anspruch 1, bei dem die Parameter des dritten Wellenleiters (16), die die Kopplung durch evaneszente Wellen zwischen dem ersten Wellenleiter (12) und dem zweiten Wellenleiter (14) beeinflussen, so ausgewählt sind, dass die Kopplung (C) größer ist als 30 %, vorzugsweise größer als 50 %.

3. Optischer Koppler nach Anspruch 1 oder 2, bei dem der dritte Wellenleiter (16) einen dritten Mantel (38) aufweist, der die untere Schicht und die obere Schicht umfasst, wobei jeder Mantel (24, 32, 38) eines Wellenleiters (12, 14, 16) einen Brechungsindex kleiner als der Brechungsindex des Kerns (20, 30, 36) jedes Wellenleiters (12, 14, 16) benachbart zum Wellenleiter (12, 14, 16) des betrachteten Mantels (24, 32, 38) aufweist.

4. Optischer Koppler nach einem beliebigen der Ansprüche 1 bis 3, bei dem der erste Wellenleiter (12) ein aktiver Wellenleiter ist und der zweite und dritte Wellenleiter (14, 16) passive Wellenleiter sind.

5. Optischer Koppler nach einem beliebigen der Ansprüche 1 bis 6, bei dem der erste Wellenleiter (12) zwei untere (26) und obere (28) Schichten, die den ersten Kern (20) umgeben, aufweist.

6. Optischer Koppler nach einem beliebigen der Ansprüche 1 bis 5, bei dem der dritte Kern (36) des dritten Wellenleiters (16) eine entlang der Querrichtung (X) variable Abmessung aufweist.

7. Optischer Koppler nach einem beliebigen der Ansprüche 1 bis 6, bei dem der zweite Wellenleiter (14) einen Abstand von mindestens 5 mm zu dem ersten Wellenleiter (12) in der Querrichtung (X) aufweist.

8. Optischer Koppler nach einem beliebigen der Ansprüche 1 bis 7, bei dem der optische Koppler (10) außerdem einen vierten Wellenleiter, unterschiedlich zu dem ersten, zweiten und dritten Wellenleiter (12, 14, 16), umfasst, der sich parallel zum ersten, zweiten und dritten Wellenleiter (12, 14, 16) erstreckt, wobei der vierte Wellenleiter zwischen dem dritten Wellenleiter (12) und dem zweiten Wellenleiter (14) angeordnet ist und Parameter aufweist, die die Kopplung durch evaneszente Wellen zwischen dem ersten Wellenleiter (12) und dem zweiten Wellenleiter (14) beeinflussen, wobei die Gesamtheit der Parameter des dritten Wellenleiters (16) und des vierten Wellenleiters so gewählt sind, dass die Kopplung (C) größer als 15 % beträgt.

9. Optischer Koppler (10) nach Anspruch 8, bei dem die Parameter des dritten Wellenleiters (16) und des vierten Wellenleiters, die die Kopplung durch evaneszente Wellen zwischen dem ersten Wellenleiter (12) und dem zweiten Wellenleiter (14) beeinflussen, so ausgewählt sind, dass die Kopplung (C) größer ist als 30 %, vorzugsweise größer als 50%.

10. Optische Komponente, einen optische Koppler (10) nach einem beliebigen der Ansprüche 1 bis 9 umfassend.

11. Verfahren zum Bestimmen von Parametern eines optische Kopplers (10) in einer vertikalen Konfiguration, umfassend:

- einen ersten Wellenleiter (12), der sich gemäß einer Längsrichtung (Z) erstreckt, wobei der erste Wellenleiter (12) einen ersten Kern (22) und einen ersten Mantel (24) umfasst, die jeweils einen Brechungsindex (nc1, ng1) aufweisen, wobei der erste Kern (20) aus einem Material hergestellt ist, das zu der Spalte III des Periodensystems gehört, zusammengesetzt mit einem Material gemäß der Spalte V des Periodensystems, und

- einen zweiten Wellenleiter (14), unterschiedlich zum ersten Wellenleiter (12) und sich parallel zum ersten Wellenleiter (12) erstreckend, wobei der zweite Wellenleiter (14) einen zweiten Kern (30) und einen zweiten Mantel (32) umfasst, die einen Brechungsindex (nc2, ng2) aufweisen, wobei der Brechungsindex (nc1) des ersten Kerns (20) des ersten Wellenleiters (12) kleiner als der Brechungsindex (nc2) des zweiten Mantels (ng2) des zweiten Wellenleiters (14) ist,

- einen dritten Wellenleiter (16), unterschiedlich zu dem ersten und zweiten Wellenleiter (12, 14) und sich parallel zu dem ersten und zweiten Wellenleiter (12, 14) erstreckend, wobei der dritte Wellenleiter (16) zwischen dem ersten Wellenleiter (12) und dem zweiten Wellenleiter (14) in einer Querrichtung (X) senkrecht zur Längsrichtung (Z) angeordnet ist und Parameter aufweist, die die Kopplung durch evaneszente Wellen zwischen dem ersten Wellenleiter (12) und dem zweiten Wellenleiter (14) beeinflussen, wobei der dritte Wellenleiter (16) eine obere Schicht (40), eine untere Schicht (42) und einen dritten Kern (36) aufweist, wobei die Parameter des dritten Wellenleiters (16), die die Kopplung durch evaneszente Wellen zwischen dem ersten Wellenleiter (12) und dem zweiten Wellenleiter (14) beeinflussen, die Abmessungen gemäß zwei senkrechte Richtungen sowie die Brechungsindices der oberen Schicht (40), der unteren Schicht (42) und des dritten Kerns (36) sind, wobei

der optische Koppler (10) ein Substrat (18) aufweist, das in einem ersten Material, vorzugsweise Silizium, hergestellt ist, in dem der zweite Wellenleiter (14) und der dritte Wellenleiter (16) vergraben sind, wobei der erste Wellenleiter (12) in Kontakt mit dem Substrat (18) angeordnet ist und aus einem Material unterschiedlich zu dem ersten Material gebildet ist; wobei das Verfahren zum Bestimmen einen Schritt des Auswählens von Parametern derart aufweist, dass die Kopplung (C) größer als 15 % ist.

12. Verfahren zur Herstellung eines optische Kopplers (10) nach einem beliebigen der Ansprüche 1 bis 9, bei dem das Herstellungsverfahren die Schritte des Herstellens unterschiedlicher Wellenleiter umfasst, die die Techniken des Abscheidens, der Epitaxie, des Polierens und Wegätzens von Material einbeziehen.

## Claims

1. An optical coupler (10) in a vertical configuration, comprising:

   - a first waveguide (12) extending in a longitudinal direction (Z), the first waveguide (12) including a first core (22) and a first cladding (24) each having an optical index (nc1, ng1), the first core (20) is made from a material belonging to column III of the periodic table formed with a material according to column V of the periodic table, and
   - a second waveguide (14) distinct from the first waveguide (12), extending parallel to the first waveguide (12), the second waveguide (14) including a second core (30) and a second cladding (32),

   the optical coupler (10) further comprising:

   - a third waveguide (16) distinct from the first and second waveguides (12, 14) and extending parallel to the first and second waveguides (12, 14), the third waveguide (16) being arranged between the first waveguide (12) and the second waveguide (14) in a transverse direction (X) perpendicular to the longitudinal direction (Z) and having parameters influencing the evanescent wave coupling between the first waveguide (12) and the second waveguide (14), those parameters being chosen such that the coupling (C) is greater than 15%, the third waveguide (16) including an upper layer (40), a lower layer (42) and a third core (36), said parameters of the third waveguide (16) influencing the evanescent wave coupling between the first waveguide (12) and the second waveguide (14) being the dimensions in two perpendicular directions as well as the optical indices of the upper layer (40), the lower layer (42) and the third core (36),

   the optical coupler (10) including a substrate (18), made from a first material that is preferably silicon, in which the second waveguide (14) and the third waveguide (16) are buried, the first waveguide (12) being arranged in contact with the substrate (18) and made from a material different from the first material, **characterized in that** the second core and the second cladding have an optical index (nc2, ng2), the optical index (nc1) of the first core of the first waveguide being lower than the optical index (ng2) of the second cladding of the second waveguide.

2. The optical coupler according to claim 1, wherein said parameters of the third waveguide (16) influencing the evanescent wave coupling between the first waveguide (12) and the second waveguide (14) are chosen such that the coupling (C) is greater than 30%, preferably greater than 50%.

3. The optical coupler according to claim 1 or 2, wherein the third waveguide (16) includes a third cladding (38) comprising said lower layer and said upper layer, each cladding (24, 32, 38) of a waveguide (12, 14, 16) having an optical index lower than the optical index of the core (20, 30, 36) of each waveguide (12, 14, 16) adjacent to the waveguide (12, 14, 16) of the considered cladding (24, 32, 38).

4. The optical coupler according to any one of claims 1 to 3, wherein the first waveguide (12) is an active waveguide and the second and third waveguides (14, 16) are passive waveguides.

5. The optical coupler according to any one of claims 1 to 6, wherein the first waveguide (12) comprises two lower (26) and upper (28) layers surrounding the first core (20).

6. The optical coupler according to any one of claims 1 to 5, wherein the third waveguide (16) includes an upper layer (40), a lower layer (42) and a core (36), the third core (36) of the third waveguide (16) having a variable dimension along the transverse direction (X).

7. The optical coupler according to any one of claims 1 to 6, the second waveguide (14) is at a distance of at least 5 millimeters from the first waveguide (12) in the transverse direction (X).

8. The optical coupler according to any one of claims 1 to 7, wherein the optical coupler (10) further comprises a fourth waveguide distinct from the first, second and third waveguides (12, 14, 16) and extending parallel to the first, second and third waveguides (12, 14, 16), the fourth waveguide being arranged between the third waveguide (12) and the second waveguide (14) and having parameters influencing the evanescent wave coupling between the first waveguide (12) and the second waveguide (14), the set of parameters of the third waveguide (16) and the fourth waveguide being chosen such that the coupling (C) is greater than 15%.

9. The optical coupler according to any one of claims 1 to 8, wherein the parameters of the third waveguide (16) and the fourth waveguide influencing the evanescent wave coupling between the first waveguide (12) and the second waveguide (14) are chosen such that the coupling (C) is greater than 30%, preferably greater than 50%.

10. An optical component comprising an optical coupler (10) according to any one of claims 1 to 9.

11. A method for determining parameters of an optical coupler (10) in a vertical configuration, comprising:

- a first waveguide (12) extending in a longitudinal direction (Z), the first waveguide (12) including a first core (22) and a first cladding (24) each having an optical index (nc1, ng1), the first core (20) is made from a material belonging to column III of the periodic table formed with a material according to column V of the periodic table, and
- a second waveguide (14) distinct from the first waveguide (12), extending parallel to the first waveguide (12), the second waveguide (14) including a second core (30) and a second cladding (32) having an optical index (nc2, ng2), the optical index (nc1) of the first core (20) of the first waveguide (12) being lower than the optical index (ng2) of the second cladding of the second waveguide (14),
- a third waveguide (16) distinct from the first and second waveguides (12, 14) and extending parallel to the first and second waveguides (12, 14), the third waveguide (16) being arranged between the first waveguide (12) and the second waveguide (14) in a transverse direction (X) perpendicular to the longitudinal direction (Z) and having parameters influencing the evanescent wave coupling between the first waveguide (12) and the second waveguide (14), those parameters being chosen such that the coupling (C) is greater than 15%, the third waveguide (16) including an upper layer (40), a lower layer (42) and a third core (36), said parameters of the third waveguide (16) influencing the evanescent wave coupling between the first waveguide (12) and the second waveguide (14) being the dimensions in two perpendicular directions as well as the optical indices of the upper layer (40), the lower layer (42) and the third core (36),

the optical coupler (10) including a substrate (18), made from a first material that is preferably silicon, in which the second waveguide (14) and the third waveguide (16) are buried, the first waveguide (12) being arranged in contact with the substrate (18) and made from a material different from the first material the method for determining including a step for choosing parameters such that the coupling (C) is greater than 15%.

12. A method for manufacturing an optical coupler (10) according to any one of claims 1 to 9, wherein the method for manufacturing comprises steps for manufacturing different waveguides involving techniques for deposition, epitaxy, polishing, gluing and material removal by etching.

*Fig.1*

*Fig.2*

*Fig.3*

premier guide d'ondes
deuxième guide d'ondes
troisième guide d'ondes

*Fig.4*

*Fig.5*

premier guide d'ondes
deuxième guide d'ondes

*Fig.6*

18

*Fig.7*

100

18

*Fig.8*

30

18

*Fig.9*

18

32

14

30

*Fig.10*

108

104

106

32

14

18

30

*Fig.11*

42

40

16

36

32

14

30

*Fig.12*

40

110

36

16

42

112

30

18    32

14

Z (μm)

*Fig.15*

X (μm)

*Fig.16*

% d'intensité lumineuse

premier guide d'ondes

deuxième guide d'ondes

troisième guide d'ondes

*Fig.13*

*Fig.14*

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 03054596 A

- US 6411765 B1

**Littérature non-brevet citée dans la description**

- **A.W SNEIDER ; J.D. LOVE.** Optical wave guide theory. Chapman and Hall, 1983